**Europäisches Patentamt**

**European Patent Office**

**Office européen des brevets**

(19)

(11) Veröffentlichungsnummer : **0 026 486**
**B2**

(12) **NEUE EUROPÄISCHE PATENTSCHRIFT**

(45) Veröffentlichungstag der neuen Patentschrift :
19.08.87

(21) Anmeldenummer : **80105840.5**

(22) Anmeldetag : **26.09.80**

(51) Int. Cl.⁴ : **H 04 N 5/44**, H 03 J 9/06

(54) **Mikroprozessorgesteuertes Fernsehgerät.**

(30) Priorität : **29.09.79 DE 2939589**

(43) Veröffentlichungstag der Anmeldung :
**08.04.81 Patentblatt 81/14**

(45) Bekanntmachung des Hinweises auf die Patenterteilung : **31.08.83 Patentblatt 83/35**

(45) Bekanntmachung des Hinweises auf die Entscheidung über den Einspruch : **19.08.87 Patentblatt 87/34**

(84) Benannte Vertragsstaaten :
**AT BE CH FR GB IT LI NL SE**

(56) Entgegenhaltungen :
**EP-A- 0 002 434**
**EP-A- 0 015 797**
**DE-A- 2 746 523**
**DE-A- 2 746 552**
**DE-A- 2 925 717**
**GRUNDIG TECHNISCHE INFORMATIONEN, Jahrgang 26, Nr. 5, November 1979, Furth, DE, H.V. SOOSTEN et al.:"Der Abstimmbaustein der Synthesizer-Geräte Super-Color 80", Seiten 256-266**
**IEEE TRANSACTIONS ON CONSUMER ELECTRONICS, Jahrgang CE-24, Nr. 3, August 1978, New York, US, C. CLIFFORD et al.: "Microprocessor based, software defined television controller", Seiten 436-441**
**ELECTRONIC COMPONENTS AND APPLICATIONS, Jahrgang 1, Nr. 4, August 1979, Eindhoven, NL, F.A.M. VAN DE KERKHOF: "Microcomputer-controlled tuning and control systems for TV", Seiten 199-214**
**FUNKSCHAU, Jahrgang 50, Nr. 8, April 1978, München, DE, R. KARNATZKI: "Infrarot-Fernbedienung mit 1024 Befehlen", Seiten 323-326**
**Elektronik, Oktober 1978, Heft 11, Seiten 49-53**
**IEEE Trans. Cons. Electron., Mai 1979, Seiten 202-209**
**Intermetall-Datenbuch 1978/79, "Integrierte Schaltun-**

(73) Patentinhaber : **LOEWE OPTA GMBH**
**Industriestrasse 11 Postfach 220**
**D-8640 Kronach (DE)**

(72) Erfinder : **Heine, Kurt**
**Jos. Aberger-Strasse 34**
**D-8211 Unterwössen (DE)**

gen für die Konsumelektronik", Ausgabe 1978/10, Seiten 28-136
Funkschau, 3. August 1979, Heft 16, Seiten 909-912
Tagungsband der 6. Jahrestagung der FKTG vom 9. bis 13. Okt. 1978 Seiten 386-389
Datenblatt SAA 1080 (MAC 6251-125-1D) der Firma Intermetall, Dezember 1977, Seiten 1-11
Funkschau, 1983, Heft 7, Seiten 106-108
Funkschau, 1984, Heft 10, Seiten 50-52

**Beschreibung**

Die Erfindung betrifft ein mikroprozessorgesteueres Fernsehgerät nach dem Oberbegriff des Patentanspruchs 1.

Aus der DE-OS Nr. 2746523 ist ein computergesteuertes nachrichtentechnisches Gerät bekannt, das im wesentlichen die vorgenannten Eigenschaften aufweist. Darüber hinaus ist den Bedienorganen der Fernbedienung eine Codierschaltung zugeordnet, die die Einstellbefehle digitalisiert und codiert, so dass jeder Einstellbefehl durch ein bestimmtes Datenwort wiedergegeben ist. In gleicher Weise werden auch die Einstellbefehle einer Ortsbedienung codiert, so dass bei gleicher Befehlsgebung gleiche Digitalwörter als Einstellbefehle an den jeweiligen Ausgängen anliegen. Die Codierung der Einstellbefehle der Fernbedienung kann nach Empfang entsprechender Analogwerte oder decodierter Digitalwerte in einer gemeinsamen Codierschaltung erfolgen, an die auch die Bedienorgane der Ortsbedienung angeschlossen sind. Die Codierschaltung ist über eine gemeinsame Datenleitung mit dem Computer des Gerätes verbunden, in welchen die codierten Befehle seriell eingelesen werden. Der Computer decodiert die binär codierten Befehle nach bestimmtem, im Computer eingeschriebenem Programm und errechnet entsprechende Mehrbit-Informationen, die als Steuerbefehle über einen Datenbus an die zu steuernden Funktionssteller zur Einstellung der einzelnen Gerätefunktionen abgegeben werden. Vorher erfolgt die Adressierung, damit nur der Funktionssteller beeinflusst wird, der gemäss dem Einstellbefehl neu eingestellt werden soll. Zu diesem Zweck gibt der Computer eine Adressmehrbit-Information über einen Adressbus ab, die in einem Adressendecoder decodiert wird. Über den Adressendecoder wird jeder zu stellende Funktionssteller einzeln angesteuert und für die Eingabe der neuen Einstellinformation freigegeben. Parallel dazu werden immer die zuletzt eingestellten Einstellinformationen mit Adresse in einem nichtflüchtigen auslesbaren Speicher im Computer abgespeichert und bei Einschalten des Gerätes durch ein eingeschriebens Programm ausgelesen und seriell in die Speicher der Funktionssteller eingeschrieben, so dass diese auf die vorgegebenen Werte eingestellt sind. In gleicher Weise erfolgt auch die Sichtanzeige durch eine über Adressbus und Datenbus angesteuerte numerische oder alphanumerische Anzeige in Form von 7-Segment-Leuchtanzeigen oder anderen Leuchtsymbolen.

Das beschriebene computergesteuerte nachrichtentechnische Gerät weist den Nachteil auf, dass eine einzige Computer-Zentraleinheit zur Einstellung sämtlicher Funktionen vorhanden ist und dadurch die Schnittstellen der Geräteschaltungen von dieser Zentraleinheit abhängig sind. Die Befehle können nur über einen Datenbus und einen gesonderten Adressbus weitergegeben werden. Eine Vielzahl von Leitungen ist deshalb zwischen Zentraleinheit und den Funktionsstellern mit ihren zugeordneten Speichern notwendig. Wenn die Zentraleinheit auf derselben Platine angeordnet ist, auf der auch die Funktionssteller angeordnet sind, werden zwar Leitungen zu den Funktionsstellern eingespart, zusätzliche Verbindungsleitungen zu der Leuchtanzeige zum Anzeigen der Stellwerte sind jedoch notwendig. Die Anzeigen, z. B. alphanumerische Leuchtziffernanzeigen, sind in der Frontplatine, also unmittelbar im Bereich der Ortsbedienung des Gerätes angeordnet, so dass für den Adress- und Datenbus eine Vielzahl von Leitungen zur Zentraleinheit vorgesehen sein muss. Sollen darüber hinaus noch andere Funktionen, die nicht seriell über den einzigen Eingang eingelesen werden können, von der Zentraleinheit verarbeitet werden, so sind hierfür von dem Bedienteil bis zur Zentraleinheit, ebenfalls zusätzliche Leitungen notwendig. Es ist ersichtlich, dass bei Ausbildung des computergesteuerten Gerätes nach dem bekannten Stand der Technik zwischen Bedienteil und dem eigentlichen Gerätechassis eine Vielzahl von Verbindungsleitungen notwendig ist. Ausserdem gestattet die Verwendung eines Mikroprozessors als Zentraleinheit nicht, dass die bereits anliegenden codierten Befehle direkt zur Einstellung der verschiedenen Funktionssteller verwendet werden können, da eine Aufrechnung nach vorgegebenen Werten und eingeschriebenem Programm erfolgt.

Aus der EP-A Nr. 0002434 ist ein mikroprozessorgesteuertes Fernsehempfangsgerät bekannt, bei dem die Funktionssteuerung über einen Mikroprozessor erfolgt, dessen abgegebene Daten und Adressen zur Funktionssteuerung an Funktionssteller gemäss der vorher beschriebenen Art und Weise ausgegeben werden. Zum Unterschied gegenüber dem Gegenstand nach DE-OS Nr. 2746523 ist der Mikroprozessor nicht in dem Fernsehempfangsgerät angeordnet, sondern im Fernbedienungsgeber. Die mittels Infrarotlicht übertragenen Befehle stellen dabei bereits direkte Einstellbefehle dar, die nach Empfang direkt an die Funktionssteller durchgeschaltet werden. Im übrigen weist diese Anordnung die gleichen Nachteile auf, wie sie bei einem mikroprozessorgesteuerten Gerät eingangs genannter Art gegeben sind.

Aus der EP-A Nr. 0015797 ist eine Schalteinheit mit einem Mikroprozessor zum Anschliessen peripherer Geräte an einen Fernsehmonitor bekannt, die die notwendigen Verbindungen sowie die Interface-Schaltüngen zum Anschluss beinhaltet. Dabei stellen die peripheren Geräte komplexe Geräte mit speziellen Ausgangssignalen dar, die über die zentrale Schalteinheit an den Monitor zur Anzeige angeschaltet werden.

Ein mikrocomputergesteuertes Gerät eingangs beschriebener Art ist auch beschrieben in « Grundig Technische Informationen », Jahrgang 26, Nr. 5, November 1979. Hier wird der Mikrocomputer in dem Fernsehempfangsgerät zur Weitergabe der Bedienfunktionen sowie zur Einstellung einer Frequenzsyntheseschaltung verwendet. Ferner dient der Mikrocomputer zur Beschaltung peripherer Geräte in Abhängigkeit eingegebener Steuerbefehle. Die bereits im ersten Abschnitt aufgeführten Nachteile sind auch bei Fernsehempfangsgeräten, die einen solchen Mikrocomputer aufweisen, der zu der bestimmten Funktion gehandhabt wird, gegeben.

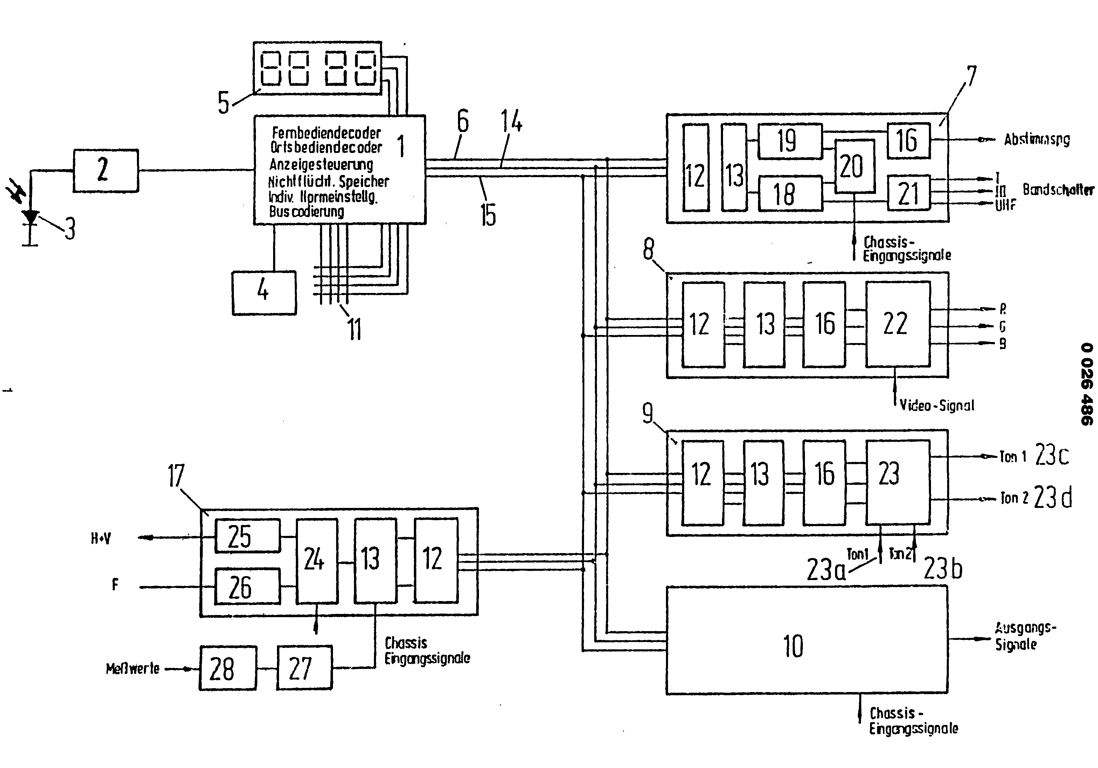

Aus « Funkschau », 1979, Heft 16, Seiten 909 bis 912, ist ferner ein mikroprozessorgesteuertes Fernsehempfangsgerät (Bild 2) bekannt, das eine Ortsbedienung und/oder eine drahtlose oder drahtgebundene Fernbedienung mit Einstellelementen für die einzelnen Funktionen aufweist. Bei Betätigung der Einstellelemente werden digitale Einstellinformationen zum Steuern, Ein- und Umschalten von variablen und festen Gerätefunktionen erzeugt, die in einem Speicher gespeichert unter Einstellung von Funktionsstellern durchgeschaltet werden. Zur speziellen Übertragung der Steuerbefehle mittels Adressen und Datenbus an die den Funktionsstellern über D/A-Wandlern zugeordneten Speicher ist eine Daten- und Steuerleitung vorgesehen.

Der Bedienteilprozessor weist mehrere Eingänge auf, in die die Eingabebefehle von der Ortsbedienung und/oder der Fernbedienung unter evtl. vorhandener Grundwerteinsteller als Digitalwerte seriell über den Eingang eingegeben werden. In dem Bedienteilprozessor werden die anliegenden Eingabebefehle in geeigneter Weise umcodiert, so daß jeder Befehl aus einem von den Funktionsstellern auslesbaren Digitalwort mit Stell- und Adresseninformationen besteht. Dem Bedienteil ist ein Schreib-/Lese-Speicher zugeordnet, der die Eingabebefehle oder die äquivalenten Digitalwörter speichert, die vom Mikroprozessor ausgelesenen, am Ausgang über einen Datenbus durch Digitalwörter seriell übertragen werden. Bei diesem mikroprozessorgesteuerten Fernsehempfangsgerät wird nach dem Prinzip der zentralen Intelligenz gearbeitet. Von einer derartigen zentralen Intelligenz in einem Farbfernsehgerät können neben der Steuerbefehlserzeugung für die Steuerung intelligenter peripherer Funktionssteller schaltungsinterne Regelgrößen einzelner Schaltungsstufen des Fernsehgerätes nur dann mit erfaßt und ausgewertet werden, wenn die Informationen vorbereitet angeboten werden.

Für die Erfassung der Regelgrößen müssen deshalb eine Vielzahl von Sensoren (Meßpunkte) in den einzelnen Schaltungsstufen vorgesehen sein und, sofern sie nicht digitaler Natur sind, in digitale Werte umgewandelt werden. Der Mikroprozessor muß eine entsprechende Anzahl von Anschlüssen aufweisen und mit zusätzlichen Interface-Schaltungen verbunden sein. Die Zuleitungen zum Mikroprozessor bzw. Interface müssen durch erhöhten Verdrahtungsaufwand hergestellt werden. Die zentrale Intelligenz bedingt auch einen hohen Rechenaufwand, der zu einer nicht vertretbaren langen Abarbeitungszeit führt.

Im beschränkten Umfang einsetzbare Mikroprozessorsteuerungen in Farbfernsehgeräten sind ferner in « Electronic Components and Applications », Volume 1, No. 4, August 1979 Seite 199 und in der Firmenschrift « Valvo Bauelemente für die gesamte Elektronik », 9. April 1979, beschrieben. Die darin verwendeten Mikroprozessoren werden in Verbindung mit Fernseh-, Abstimm-, Bedien- und Anzeigesystemen in der Weise verwendet, daß die Einstellbefehle von diesen programmgesteuert weitergegeben werden.

Komfort-Bedienungsschaltungen, die ausgesteuert sind, sind weiterhin für Hifi-Anlagen mit einer Infrarot-Fernbedienung für 37 Funktionen aus « Funkschau », 1979, Heft 13, Seite 753 ff., bekannt. Der Fernsteuerempfänger gibt dabei die Einstellbefehle über einen Datenbus, ähnlich wie bei mikroprozessorgesteuerten Systemen, an die Funktionssteller weiter. Als möglicher Funktionssteller ist auch ein Spielmodul anzusehen, der in der Firmenschrift « Intermetall Halbleiterwerk » der Deutschen ITT Industries, Ausgabe Dezember 1977, unter der Bezeichnung « SAA 1080 » beschrieben ist.

Keines der genannten busgesteuerten Bedienungssysteme weist jedoch in Bezug auf die angesteuerten Funktionssteller und Schaltungskomponenten des Fernsehempfangsgerätes selbsttätig regelnde Systeme und Steuereinheiten auf.

Grundsätzlich sind Mikroprozessor-Steuersysteme in Verbindung mit Studioanlagen zum Anschalten verschiedener Anlagen für den Senderbetrieb aus « FKTG-Tagungsband » 1978, Seite 384 ff., und Multiprozessorsysteme für hierarchisch aufgebaute Rechnersysteme aus « Elektronik », 1978, Heft 10, sowie « Elektronik », 1978, Heft 11, Seite 84 ff., bekannt. Die darin beschriebenen Multiprozessorsysteme sind jedoch nicht ohne weiteres auf den Erfindungsgegenstand übertragbar, da sie entweder speziell auf Studiotechnik ausgerichtet sind oder nur global die Möglichkeit des Datenflusses zwischen einzelnen Mikroprozessoren angeben.

Ausgehend Von dem beschriebenen Stand der Technik liegt der Erfindung die Aufgabe zugrunde, die aufgezeigten Nachteile der bekannten Systeme durch eine entsprechende Ausbildung des mikroprozessorgesteuerten Gerätes und durch entsprechende Wahl der Schnittstellen unter Anwendung eines dezentralen Systems zu vermeiden, wobei die speziell mit dem Uni-Bus-System erzielbaren Vorteile bei minimalem Verdrahtungsaufwand realisiert werden sollen. Darüber hinaus sollen bei minimalem Rechenaufwand und kurzer Abarbeitungzeit die Steuer- und Regelfunktionen der Funktionsbausteine sichergestellt sein, ohne daß dadurch die zu übertragende Datenmenge die maximale Übertragungsleistung des Steuersystems übersteigt. Außerdem soll eine Integration von bestimmte Funktionen steuernden Funktionsstellern mit den Ansteuerschaltungen ermöglicht werden, wobei durch eigene Prozessorsteuerung in der Form einer Nachregelung die eingestellten Funktionen in Abhängigkeit von im Gerät abgegriffenen Größen möglich sind.

Die Aufgabe wird erfindungsgemäss nach der im Patentanspruch 1 wiedergegebenen technischen Lehre gelöst.

Vorteilhafte Weiterbildungen der Erfindung sind in den Unteransprüchen beschrieben.

Durch die Verwendung verschiedener, den einzelnen Funktionen zugeordneten Zentraleinheiten ist sichergestellt, dass das Bedienteil mit seinem Bedienteil-Prozessor, den Anzeige- und Eingabelementen sowie dem Fernbedienungsgeber, Verstärker und Decodierer eine zentrale Einheit bildet, die z. B. unmittelbar hinter der Gerätefront eines Fernseh- oder Rundfunk- bzw. Hi-Fi-Gerätes angeordnet sein kann. Die Verbindung zu dem Chassis, in dem die Eingangssignale (HF/NF-Signale) für die Wiedergabe verarbeitet werden, erfolgt über einen Datenbus und die für die Synchronisation und Ansteuerung notwendigen Leitungen, wie Takt- und Freigabeleitungen.

Ein gesonderter Adressbus ist bei dem System nicht notwendig, da die Funktionsprozessoren, die einzelne, für sich allein funktionsfähige Steuereinheiten bilden, aus dem angelieferten Datenmaterial die Adressierung und die Einstellinformation selbst herauslesen, so dass nur die Funktion, die von einem Funktionsprozessor gesteuert werden soll, durch Eingabe über das Bedienorgan eingestellt wird. Beim Einschalten des Gerätes werden die in dem Bedienteil-Prozessor anliegenden Grundwerte der einzelnen Funktionen übertragen und die Funktionsprozessoren entsprechend vorbereitet. Selbstverständlich kann eine Grundeinstellung auch durch entsprechende Programmierung des Funktionsprozessors bzw. durch Vorgabe bestimmter Speicherdaten in den Datenspeicher der Prozessoren bewerkstelligt werden, wozu den Funktionsprozessoren Einsteller zugeordnet sind. Um jedoch eine individuelle Normeneinstellung zu ermöglichen, ist es zweckdienlich, gewisse Funktionen vom Bedienenden selbst einstellen zu lassen, z. B. die Grundeinstellungen Lautstärke, Helligkeit, Farbe, Balance, Kontrast, Feinabstimmung, Tiefe, Höhe usw. Die Verwendung von verschiedenen Prozessoren, die für sich je eine Steuer- und Regeleinheit bilden, in dem Gerät ermöglicht, dass bei der Erstellung der Prozessoren ein hoher Integrationsgrad erzielt werden kann, was letzlich zu einer wesentlichen Verbilligung der Geräte führt. Auch ist es möglich, bei Funktionsgeneratoren, die Adress- und Datendecoder, Datenspeicher und D/A-Wandler aufweisen, diese für die verschiedenen Funktionsgeneratoren gleichförmig auszubilden, wobei lediglich die Ausgänge mit verschiedenen Analog bzw. Digitalstellern verbunden und durch die notwendigen Interface-Schaltungen ergänzt werden müssen. Eine Vereinheitlichung von Funktionsprozessoren mit gleichen Steuergrössen ist somit ebenfalls möglich.

Die Erfindung sowie weitere Vorteile, die durch ihre Anwendung gegeben sind, werden nachfolgend in einem Ausführungsbeispiel für ein Fernsehempfangsgerät anhand des in der Figur dargestellten Blockschaltbildes näher erläutert.

In dem Blockschaltbild sind nur die erfindungswesentlichen Baugruppen dargestellt. Chassisausbildungen bzw. Signale, die vom Chassis entnommen werden und durch die Funktions-Steuerprozessoren beeinflusst werden sollen, sind nicht dargestellt. Der Eingabebaustein besteht aus einem Bedienteil-Prozessor 1, der im wesentlichen beinhaltet : einen Fernbedienungsdecoder, einen Ortsbedienungsdecoder, eine Anzeigesteuerung, einen nichtflüchtigen Speicher zur Abspeicherung der eingegebenen Befehlswörter, eine Schaltungsanordnung zur individuellen Normeneinstellung sowie eine Buscodierschaltung, die die Eingabebefehle in für das System auswertbare Digitalwörter in einem bestimmten Code codiert, welche Digitalwörter Mehrbit-Stellinformationen und die Adresse beinhalten. Der Bedienteil-Prozessor 1 ist über einen Eingang mit einem Infrarot-Empfänger 2 verbunden, an dem eine Infrarot-Empfangsdiode 3 angeschlossen ist. Von einem Fernbedienungsgeber, der nicht dargestellt ist, werden bei Betätigung der entsprechenden Funktionstasten codierte Digitalwörter übertragen oder der Betätigungszeit proportionale Signale drahtlos auf Infrarotlicht moduliert und in der Empfängerschaltung verstärkt und demoduliert. Die abgehenden Signale werden dem Fernbedienungsdecoder im Bedienteil-Prozessor zugeführt, der die Signale decodiert und in solche umwandelt, die vom System auswertbar sind. In ähnlicher Weise erfolgt die Eingabe mittels einer Ortsbedienung 11, die nur symbolisch durch eine Matrixschaltung dargestellt ist. Selbstverständlich kann auch hier eine serielle Dateneingabe erfolgen. Wie bei der Infrarot-Übertragung in einfacher Ausführung, kann sie jedoch auch parallel erfolgen, wozu die Bedienorgane über eine Matrixschaltung miteinander verknüpft sind. Ferner sind über einen weiteren Eingang Grundwerteinsteller 4 mit dem Bedienteil-Prozessor 1 verbunden. Die Grundwerteinsteller 4, Laut/Leise, Hell/Dunkel, Farbe, Balance, Kontrast usw. , können auch serielle Daten abgeben, zu welchem Zwecke eine Codierschaltung vorzusehen ist. Mit den Grundwerteinstellern werden die verschiedenen Funktionen, den individuellen Wünschen des Bedienenden angepasst, auf einen Normwert eingestellt, der beim Einschalten des Gerätes stets gegeben ist. Für die Eingabe ist innerhalb des Bedienteil-Prozessors 1 eine Schaltungsanordnung zur individuellen Normeneinstellung vorhanden, die die anliegenden Signale in den nichtflüchtigen Speicher eingibt, der bei Einschalten des Gerätes ausgelesen wird. Die von der Ortsbedienung 11 abgegebenen Einstellbefehle werden ebenfalls in dem integrierten Ortsbedienungsdecoder decodiert. Verschiedene Daten sollen jedoch auch parallel in einer Leuchtziffernanzeige 5 angezeigt werden, z. B. die eingestellte Frequenz oder die Lautstärke als Ziffer der Leuchtdiodenreihe u. dgl. Dies erfolgt über die im Prozessor 1 vorhandene Anzeigesteuerung, die bei Betätigung der entsprechenden Funktionstasten sofort wirksam wird und den eingestellten Wert sichtbar darstellt. Die Anzeige 5 ist dem Bedienteil-Prozessor direkt zugeordnet, so dass die gesamte Bedienteileinheit unabhängig vom Chassis unmittelbar hinter der Gerätefront angebracht werden kann. In dem Bedienteil-Prozessor werden sämtliche Einstellbefehle nach der Decodierung in vom System verarbeitbare Digitalwörter umgewandelt. Diese beinhalten die für die Adressierung notwendigen Daten und die Mehrbit-Einstellinformation für die entsprechenden Funktionsprozessoren und werden über den Datenbus 6 seriell geschrieben und an alle Eingänge der angeschlossenen Funktionsprozessoren gelegt. Für ein Fernsehempfangsgerät, wie es hier dargestellt ist, sind vorhanden : ein Abstimmprozessor 7, ein Videoprozessor 8, ein Tonprozessor 9, ein Subsystemprozessor 10 und ein Ablenkprozessor 17. Die einzelnen Funktionsprozessoren sind so ausgebildet, dass sie bei Erkennen der zugeordneten Adresse ansprechen und die Mehrbit-Stellinformation annehmen. Für die Blockierung ist ferner vorgesehen eine Taktleitung (Clock) 14 und eine Freigabeleitung (DLEN) 15, die ihre Signale von dem Bedienteil-Prozessor 1 zur Synchronisation und zur Freigabe erhalten. Für die entsprechende Verknüpfung ist es voreilhaft, in dem Bedienteil-Prozessor 1 einen Mikroprozessor vorzusehen, der die entsprechenden Befehle nach eingeschriebenem Programm ausgibt. Werden jedoch von den Bedienorganen bereits Mehrbit-Stellinformationen einschliesslich Adressierung ausgegeben, die von den Funktionsprozessoren 7, 8, 9, 10, 17 direkt verarbeitet werden können, so ist keine Decodierung und auch keine Aufrechnung mehr notwendig, sondern die Befehle werden direkt als Stellbefehle ausgewertet. Der Abstimmprozessor 7 weist, wie alle anderen Funktionsprozessoren auch, einen Adress- und Busdecoder 12 auf, der die adressierten Befehle entgegennimmt und diese an einen Datenspeicher 13 abgibt und abspeichert. In einem zusätzlichen, nichtflüchtigen, auslesbaren Speicher 18 müssen auch die Befehle der Bandumschaltung eingeschrieben sein, so dass bei Anschalten des Gerätes auch das entsprechende Frequenzband eingeschaltet ist und die Daten zur Abstimmung des Gerätes weiterverarbeitet werden können. Zu diesem Zweck ist eine Ablaufsteuerschaltung 19 vorgesehen, der ein D/A-Wandler 16 zur Erzeugung der entsprechenden Abstimmspannung zugeordnet ist. An dem Ausgang des nichtflüchtigen Programmspeichers 18 ist ein Treiber 21 angeschlossen, der die einzelnen Bandumschalter I, III und UHF beschaltet. Das Chassiseingangssignal, in diesem Fall, das Antennensignal, liegt an der Eingangsschaltung 20 an, die mit der von der Einstellinformation eingestellten Ablaufsteuerschaltung 19 verbunden ist. Bei Verwendung einer Frequenzsyntheseschaltung tritt an die Stelle einer analogen Auswertung die digitale Frequenzteilung. Durch die Einstellinformationen wird dabei das Teilerverhältnis von Frequenzteilern eingestellt, um die notwendige Abstimmspannung in bekannter Weise bei solchen Systemen zu erzeugen. Entsprechend aufwendig ist in diesem Fall die Ablaufsteuerschaltung 19.

Der Videoprozessor 8 weist die gleichen Grundbausteine, Adress- und Busdecoder 12 sowie einen Datenspeicher 13 und einen nachgeschalteten D/A-Wandler 16 auf, der nur dann notwendig ist, wenn keine digitale Einstellung möglich ist, sondern auf analoge Schaltungen als Signalverarbeitungsschaltung zurückgegriffen wird. Helligkeit, Kontrast und Farbe werden im Analogteil 22 geregelt und das anliegende Videosignal entsprechend beeinflusst. Die Ausgangssignale R, G, B werden den RGB- Endstufen zugeführt.

Auch der Tonprozessor 9 weist Adresse und Busdecoder 12 sowie Datenspeicher 13 und D/A-Wandler 16 auf. Letzterer ist nur dann notwendig, wenn eine digitale Einstellung der zu regelnden Grössen, wie Lautstärke, Höhen, Tiefen und Balance nicht möglich ist. Darüber hinaus kann der Tonprozessor aber auch mittels eingeschriebenem Programm bei Anliegen von Mehron-Verfahren bzw. anderen Tonübertragungssystemen den Analogteil 23 mit der Regelungsschaltung für diese entsprechenden Empfangsmöglichkeiten aktivieren. Am Eingang sind zwei Toneingänge 23 a, b und am Ausgang zwei Tonausgänge 23 c, d vorgesehen. Entsprechend dem verwendeten Mehrton-Verfahren kann die Anzahl der Ein- und Ausgänge erweitert oder eingeschränkt werden.

Der Synchron- und Ablenkprozessor 17 weist ebenfalls einen Busdecoder 12 und einen Datenspeicher 13 auf. In einer Signalaufbereitungsschaltung 24, die durch die Einstellinformation programmiert wird, werden aus dem anliegenden Chassis-Eingangssignal die verschiedenen Synchronsignale, wie Horizontal-, Verikal- und Farbsynchronsignale, sowie synchronisierte Hilfssignale gewonnen und den nachgeschalteten Interface-Schaltungen 25, 26 zugeführt, deren Ausgänge mit den Chassis-Schaltungen und den zu synchronisierenden Funktionsprozessoren verbunden sind. Mit dem Funktionsprozessor 17 ist ein Mikroprozessor 27 verbunden, an dem eine Messschaltung 28 angeschlossen ist, die über ihre Eingänge Messdaten von verschiedenen Messpunkten im Chassis erhält. Der Mikroprozessor 27 vergleicht die Messdaten mit im Datenspeicher 13 vorgegebenen Werten und steuert direkt oder indirekt über den Funktionsprozessor 17 den Signalfluss durch die Funktionsprozessoren oder das Chassis. Bei Auftreten von Defekten können über Schalter Teile des Gerätes abgeschaltet oder andere Signalwerte angeschaltet oder Einstellinformationen verändert werden.

Der Subsystemprozessor 10, der einen einzigen Baustein bildet, gestattet die Signalverarbeitung für Video, Bildschirmtext, Spiele und Bildaufzeichnung, zu welchem Zweck die Chassissignale an einen Eingang angelegt und entsprechend den Einstellinformationen beeinflusst werden, so dass die Ausgangssignale in gewünschter Weise auf dem Bildschirm dargestellt werden. Eingangsseitig weist der Subsystemprozessor 10 ebenfalls Adressbusdecoder 12 und Datenspeicher 13 auf. Diesen Teilen sind digitale und analoge Signalverarbeitungsschaltungen nachgeschaltet.

Durch die Aufteilung in Funktionsprozessoren und Bedienteil-Prozessor ist es möglich, Bedienteil und Chassissteuerung völlig getrennt voneinander auszubilden und über eine einzige Datenleitung miteinander zu verbinden. Übliche Verkabelungen werden dadurch vermieden und eine übersichtliche Bauanordnung ermöglicht.

**Patentansprüche**

1. Mikroprozessorgesteuertes Fernsehgerät mit einer Ortsbedienung (11) und/oder einer drahtlosen oder drahtgebundenen Fernbedienung (2, 3) mit Einstellelementen für die einzelnen Funktionen, bei deren Betätigung digitale Einstellinformationen zum Steuern, Ein- und Umschalten von variablen und festen Gerätefunktionen erzeugt werden, die in einem Speicher (1) gespeichert und zur Einstellung von Funktionsstellern durchgeschaltet werden, mit einer Datenleitung (6) und einer Steuerleitung (14, 15) zur speziellen Übertragung der Steuerbefehle mittels Adressen und Datenbus an die den Funktionsstellern über D/A-Wandler zugeordneten Speicher (13) und mit einem Bedienteilprozessor (1) mit mehreren Eingängen, in die die Eingabebefehle von der Ortsbedienung (11) und/oder der Fernbedienung (2, 3) und evtl. vorhandener Grundwerteinsteller (4) als Digitalwerte eingegeben werden, welcher Bedienteilprozessor (1) die anliegenden Eingabebefehle in einer Codierschaltung codiert oder in geeigneter Weise umcodiert, so daß jeder Befehl aus einem von den Funktionsstellern auslesbaren Digitalwort mit Stell- und Adresseninformationen besteht, und nur einem dem Bedienteil zugeordneten nichtflüchtigen auslesbaren Speicher (1), der die Eingabebefehle oder die äquivalenten Digitalwörter speichert und am Ausgang über einen Datenbus (6) durch Digitalwörter seriell überträgt, gekennzeichnet durch die Kombination mit Funktionsprozessoren (7, 8, 9, 10, 17), die Adress- und Busdecoder (12), Datenspeicher (13) und digitale und/oder analoge Funktionssteller mit zugeordneten Digitalanalogwandlern (16) aufweisen, an deren Eingängen die seriell geschriebenen Digitalwörter gleichzeitig anliegen, von denen jedoch nur der Adress- und Busdecoder (12), der durch die der Information vorangestellten Adresse adressiert und über die Steuerleitung (14, 15 ; Clock, DLEN) freigegeben ist, die adressierten Befehle entgegennimmt und diese an den Datenspeicher (13) zum Abspeichern abgibt, welche Funktionsprozessoren (7, 8, 9, 10, 17) weitere Eingänge aufweisen, über die nach den Einstellbefehlen zu beeinflussende vom Chassis abgegriffene Signale eingespeist werden, indem an den Datenspeicher (13) des Funktionsprozessors (7, 8, 9, 10, 17) eine Steuer- und/oder Regelschaltung (19) angeschaltet ist, die die vorgegebenen Daten mit im Gerät über die Steuerung- und/oder Regelschaltung (19) abfragbaren Daten vergleicht und entsprechend der Ist/Sollwertabweichung das zu beeinflussende Signal nachsteuert bzw. den Signaldurchgang schaltet.

2. Mikroprozessorgesteuertes Fernsehgerät nach Anspruch 1, dadurch gekennzeichnet, dass mit dem Bedienteil-Prozessor (1) eine numerische oder alphanumerische Leuchtanzeige (5) verbunden ist, die durch Eingabe eines entsprechenden Steuerbefehls von der Fernbedienung (2, 3) oder der Ortsbedienung (11) die anzeigbaren Funktionsstellwerte oder die Wertänderungen anzeigt, die durch einen Eingabebefehl aus dem Speicher des Bedienteil-Prozessors (1) abgerufen werden.

3. Mikroprozessorgesteuertes Fernsehgerät nach einem der beiden Ansprüche 1 oder 2, dadurch gekennzeichnet, dass die Eingabe der Einstellbefehle von der Fernbedienung (2, 3) seriell und die der Ortsbedienung (11) parallel über eine Matrixschaltung in den Bedienteil-Prozessor (1) erfolgen, und dass die Decodierung und Buscodierung der einzelnen Einstellbefehle nach eingeschriebenem Programm oder in Decodier- und Codierschaltungen erfolgt.

4. Mikroprozessorgesteuertes Fernsehgerät nach Anspruch 1, dadurch gekennzeichnet, dass ein Abstimmprozessor (7), ein Videoprozessor (8), ein Tonprozessor (9), ein Synchronisier- und Ablenkprozessor (17) und ein Subsystemprozessor (10) als Funktionsprozessoren vorgesehen sind.

5. Mikroprozessorgesteuertes Fernsehgerät nach Anspruch 4, dadurch gekennzeichnet, dass der Abstimmprozessor (7) einen Adress- und Busdecoder (12), einen Datenspeicher (13), einen nichtflüchtigen Programmspeicher (18) mit Programmspeicherschaltung sowie Bandumschaltung, eine Ablaufsteuerschaltung (19), an welcher die Chassis-Eingangssignale anliegen, die nach den Einstellbefehlen durch die Funktionssteller beinflusst werden, einen D/A-Wandler (16) zur Erzeugung der Abstimmspannung in analogen Abstimmsystem bzw. einer Teilerschaltung, in der das Teilerverhältnis zur Einstellung von Abstimmsystemen mit Frequenzsyntheseschaltungen eingestellt wird, und eine von der Anlaufsteuerung angesteuerte, aus dem nichtflüchtigen Speicher (18) die Information erhaltende Treiberschaltung (21) zum Umschalten auf die verschiedenen Empfangsbereiche (I, III, UHF) aufweist.

6. Mikroprozessorgesteuertes Fernsehgerät nach Anspruch 4, dadurch gekennzeichnet, dass der Videoprozessor (8) einen Adress- und Busdecoder (12), einen Datenspeicher (13) zum Speichern der Einstellbefehle, einen D/A-Wandler (16) zur Erzeugung der Einstellspannung für Helligkeit, Kontrast und Farbe und eine Analog-Regelschaltung (22) mit den für die Regelung notwendigen Funktionsstellern aufweist, an welcher Analog-Regelschaltung das Videosignal anliegt, aus dem in der Analog-Regelschaltung in einer Matrixschaltung die Rot-, Grün, Blau-Signale in bekannter Weise erzeugt und über die Ausgänge abgegeben werden.

7. Mikroprozessorgesteuertes Fernsehgerät nach Anspruch 4, dadurch gekennzeichnet, dass der Tonprozessor (9) einen Adress- und Busdecoder (12), einen Datenspeicher (13) zur Einspeicherung der entsprechenden Einstellbefehle, einen D/A-Wandler (16) zur analogen Regelung bzw. digitale Funktionssteller aufweist, welcher D/A-Wandler (16) mit einem Analogteil (23) der Funktionssteller verbunden ist, in welchem die Tonsignale beim Mehrton-Verfahren matriziert oder über einen Kanal entsprechend den anliegenden Stellbefehlen Lautstärke, Höhe, Tiefe, Balance geregelt und über die Ausgänge abgegeben werden.

8. Mikroprozessorgesteuertes Fernsehgerät nach Anspruch 4, dadurch gekennzeichnet, dass der Subsystemprozessor (10) einen Adress- und Busdecoder und einen Datenspeicher sowie digitale und analoge Funktionssteller aufweist, die die anliegenden Eingangssignale vom Chassis oder vom HF-Eingang entsprechend der eingegebenen Signalaufarbeitung decodieren, codieren oder beeinflussen, z. B. für Videotext, Bildschirmtext, Bildschirmspiele und Bildaufzeichnungssysteme.

9. Mikroprozessorgesteuertes Fernsehgerät nach Anspruch 4, dadurch gekennzeichnet, dass der Synchronisier- und Ablenkprozessor (17) neben dem Busdecoder (12), dem Datenspeicher (13) eine von den Einstellbefehlen wirksam geschaltete Synchronsignalaufbereitungsschaltung (24) zur Erzeugung der Horizontal- und Vertikalsynchronsignale sowie Farbsynchronsignale und Hilfssignale (sand castle-Impulse) aufweist.

**Claims**

1. Microprocessor-controlled television appliance with a local control (11) and/or a wireless or wire-connected remote control (2, 3), with setting elements for the individual functions, on the actuation of which digital or analog setting information data for the control and switching on and off of variable and fixed appliance functions are generated, which data are stored in a store (1) and switched through for the setting of function setters, with a data line (6) and a control line (14, 15) for the special transmission of the control commands by means of addresses and data bus to the stores (13) associated by way of digital-to-analog convertors with the function setters and with a control-part processor (1) with several inputs, into which the input commands from the local control (11) and/or the remote control (2, 3) and possibly present base value setters (4) are given in as digital values, which control-part processor (1) encodes the present input commands in a coding circuit or recodes them in suitable manner so that each command consists of a digital word with setting and address information data readable out from the function setters, and only one non-volatile readable store (1), which is associated with the control part and which stores the input commands or the equivalent digital words and transmits them serially through digital words by way of a data bus (6) at the output, characterised by the combination with function processors (7, 8, 9, 10, 17), which display address and bus decoders (12), data stores (13) and digital and/or analog function setters with associated digital-to-analog converters (16), at the inputs of which the serially written words are present simultaneously, of which however only that address and bus decoder (12) accepts the addressed commands and delivers these to the data store (13) for storage, which is addressed by the address placed in front of the information data and which is freed through the control lines (14, 15 ; clock, DLEN), which function processors (7, 8, 9, 10, 17) display furher inputs, through which the signals are fed in, which are to be influenced according to the setting commands and taken off from the chassis, in that a control and/or regulating circuit (19), which compares the preset data with data interrogatable through the control and/or regulating circuit (19) in the appliance and which in correspondence with the deviation of the actual value from the intended value readjusts the signal to be influenced or switches the signal passage, is connected to the data store (13) of the function processor (7, 8, 9, 10, 17).

2. Microprocessor-controlled television appliance according to claim 1, characterised thereby, that connected with the control-part processor (1) is a numerical or alpha-numerical indication (5), which through input of a corresponding control command from the remote control (2, 3) or the local control (11) indicates the indicatable function setting values or the value changes, which due to an input command are called up out of the store of the control-part processor (1).

3. Microprocessor-controlled television appliance according to claim 1 or 2, characterised thereby, that the input of the setting commands from the remote control (2, 3) takes place serially and that of the local control (11) parallelly through a matrix circuit into the control-part processor (1) and that the decoding and bus-encoding of the individual setting commands takes place according to a program which has been written in or in decoding and encoding circuits.

4. Microprocessor-controlled television appliance according to claim 1, characterised thereby, that a tuning processor (7), a video processor (8), a sound processor (9), a synchronising and deflection processor (17) and a subsystem processor (10) are provided as function processors.

5. Microprocessor-controlled television appliance according to claim 4, characterised thereby, that the tuning processor (7) displays an address and bus decoder (12), a data store (13), a non-volatile program store (18) with program storage circuit as well as band change-over switching, a run-down control circuit (19), at which the chassis input signals are present, which are influenced by the function setters according to the setting commands, a digital-to-analog converter (16) for the generation of the tuning voltage in analog tuning systems, or a divider circuit, in which the divider ratio for the setting of tuning systems with frequency synthesis circuits is set, and a driver circuit (21), which is driven by the start-up control and receiving the information data from the non-volatile store (21), for switching over to the different reception ranges (I, III, UHF).

6. Microprocessor-controlled television appliance according to claim 4, characterised thereby, that the video processor (8) displays an address and bus decoder (12), a data store (13) for the storage of the setting commands, a digital-to-analog converter (16) for the generation of the setting voltage for brightness, contrast and colour and an analog regulating circuit (22) with the function setters necessary for the regulation, at which analog regulating circuit the video signal is present, from which the red, green and blue signals are generated in known manner in a matrix circuit in the analog regulating circuit and delivered through the outputs.

7. Microprocessor-controlled television appliance according to claim 4, characterised thereby, that the sound processor (9) displays an address and bus decoder (12), a data store (13) for the putting into storage of the corresponding setting commands, a digital-to-analog converter (16) for the analog regulation or digital function setters, which digital-to-analog converter (16) is connected with an analog part (23) of the function setters, in which part the sound signals in the multiple sound process are matrixed or regulated through one channel in correspondence with the setting commands for volume, treble, bass and balance and delivered through the outputs.

8. Microprocessor-controlled television appliance according to claim 4, characterised thereby, that the subsystem processor (10) displays an address and bus decoder and a data store as well as digital and analog function setters, which decode, encode or influence the input signals present from the chassis or from the VHF-input in correspondence with the signal conditioning put in, for example for video text, picture screen text, picture screen games and picture recording systems.

9. Microprocessor-controlled television appliance according to claim 4, characterised thereby, that the synchronising and deflection processor (17), besides the bus decoder (12) and the data store (13), displays a synchronising signal preparation circuit (24), which is switched to become effective by the setting commands for the generation of the horizontal and vertical synchronising signals as well as colour synchronising signals and auxiliary signals (sand castle pulses).

**Revendications**

1. Téléviseur commandé par microprocesseur, comportant une manœuvre locale (11) et/ou une manœuvre à distance sans fin ou à fil (2, 3), des éléments de réglage des différentes fonctions dont l'actionnement engendre des informations numériques de réglage pour la commande, l'établissement et la commutation de fonctions variables et fixes d'appareil qui sont mémorisées dans une mémoire (1) et transmises pour régler des organes de réglage de fonction, une ligne de données (6) et une ligne de commande (14, 15) pour la transmission spéciale des ordres de commande au moyen d'adresses et d'un bus de données aux mémoires (13) adjointes aux organes de réglage de fonction par l'intermédiaire de convertisseurs N/A, un processeur de partie de manœuvre (1) muni de plusieurs entrées dans lesquelles sont introduits les ordres d'introduction venant de la manœuvre locale (11) et/ou de la manœuvre à distance (2, 3) et d'organes de réglage de valeur fondamentale (4) éventuellement prévus, en tant que valeurs numériques, lequel processeur de partie de manœuvre (1) code dans un circuit codeur les ordres d'introduction existants ou les transcode de façon appropriée, de sorte que chaque ordre est formé d'un mot numérique lisible par les organes de réglage de fonction, avec informations de réglage et d'adresse, une mémoire non volatile (1) lisible adjointe à la partie de manœuvre et qui mémorise les ordres d'introduction ou les mots numériques équivalents et les transmet en série à la sortie, en passant par un bus de données (6), par des mots numériques, caractérisé par la combinaison avec des processeurs de fonction (7, 8, 9, 10, 17) qui présentent des décodeurs d'adresse et de bus (12), des mémoires de données (13) et des organes numériques et/ou analogiques de réglage de fonction avec convertisseurs numériques/analogiques (16) adjoints, aux entrées desquels existent simultanément les mots numériques écrits en série, mais dont seul le décodeur d'adresse et de bus (12) qui est adressé par l'adresse ayant précédé l'information est libéré par la ligne de commande (14, 15, Clock, DLEN), accepte les ordres adressés et transmet ceux-ci à la mémoire de données (13) pour la mémorisation, lesquels processeurs de fonction (7, 8, 9, 10, 17) présentent d'autres entrées par lesquelles sont introduits les signaux tirés du châssis et devant être influencés selon les ordres de réglage, en ce sens que, à la mémoire de données (13) du processeur de fonction (7, 8, 9, 10, 17) est relié un circuit de commande et/ou de régulation (19) qui compare les données prescrites à des données pouvant être appelées dans l'appareil par l'intermédiaire du circuit de commande et/ou de régulation (19), et, conformément à l'écart entre valeur instantanée et valeur de consigne, réajuste le signal à influencer ou commute le passage du signal.

2. Téléviseur commandé par microprocesseur selon la revendication 1, caractérisé par le fait qu'au processeur de partie de manœuvre (1) est relié un affichage lumineux (5) numérique ou alphanumérique qui, par introduction d'un ordre de commande correspondant venant de la commande à distance (2, 3) ou de la commande locale (11), affiche les valeurs de réglage de fonction pouvant être affichées ou les variations de valeur qui sont appelées de la mémoire du processeur de partie de manœuvre (1) par un ordre d'introduction.

3. Téléviseur commandé par microprocesseur selon l'une des revendications 1 et 2, caractérisé par le fait que l'introduction des ordres de réglage venant de la manœuvre à distance (2, 3) dans le processeur de partie de manœuvre (1) s'effectue en série et celle de la manœuvre locale (11) en parallèle, par l'intermédiaire d'un circuit de matrice et que le décodage et le codage de bus des différents ordres de réglage s'effectuent selon un programme inscrit ou dans des circuits décodeurs et codeurs.

4. Téléviseur selon la revendication 1, caractérisé par le fait qu'un processeur d'accord (7), un processeur vidéo (8), un processeur de son (9), un processeur de synchronisation et de déviation (17) et un processeur de sous-système (10) sont prévus comme processeurs de fonction.

5. Téléviseur selon la revendication 4, caractérisé par le fait que le processeur d'accord (7) présente un décodeur d'adresse et de bus (12), une mémoire de données (13), une mémoire de programme non volatile (18) avec circuit de mémoire de programme et commutation de bande, un circuit de commande de déroulement (19) auquel sont appliqués les signaux d'entrée du châssis qui sont influencés, selon les ordres de réglage, par les organes de réglage de fonction, un convertisseur numérique/analogique (16) servant à engendrer la tension d'accord dans des systèmes analogiques d'accord ou dans un circuit diviseur dans lequel le rapport de division est réglé pour régler des systèmes d'accord munis de circuits de synthèse de fréquence, et un circuit excitateur (21) commandé par la commande de déroulement et recevant l'information de la mémoire non volatile (18) pour commuter aux différentes gammes de réception (I, III, UHF).

6. Téléviseur selon la revendication 4, caractérisé par le fait que le processeur vidéo (8) présente un décodeur d'adresse et de bus (12), une mémoire de données (13) pour la mémorisation des ordres de réglage, un convertisseur numérique/analogique (16) servant à engendrer la tension de réglage de luminosité, de contraste et de couleur et un circuit analogique de régulation (22) muni des organes de réglage de fonction nécessaire à la régulation et auquel est appliqué le signal vidéo au départ duquel, dans le circuit analogique de régulation, dans un circuit de matrice, les signaux rouges, verts et bleus sont engendrés de façon connue et émis par les sorties.

7. Téléviseur selon la revendication 4, caractérisé par le fait que le processeur de son (9) présente un décodeur d'adresse et de bus (12), une mémoire de données (13) pour la mémorisation des ordres de réglage correspondants, un convertisseur numérique/analogique (16) pour la régulation analogique ou des organes numériques de réglage de fonction, le convertisseur numérique/analogique (16) étant relié à une partie analogique (23) des organes de réglage de fonction, dans laquelle les signaux de son, dans le cas du procédé à plusieurs sons, sont mis sous forme de matrice ou sont réglés en passant par un canal conformément aux ordres de commande existants pour la puissance sonore, la hauteur, la profondeur et l'équilibrage et sont émis par les sorties.

8. Téléviseur selon la revendication 4, caractérisé par le fait que le processeur de sous-système (10) présente un décodeur d'adresse et de bus et une mémoire de données ainsi que des organes numériques et analogiques de réglage de fonction qui décodent, codent ou influencent les signaux d'entrée existants venant du châssis ou de l'entrée HF, conformément au traitement de signaux introduits, par exemple pour le vidéotexte, le texte sur l'écran, les jeux sur écran et les systèmes d'enregistrement d'images.

9. Téléviseur selon la revendication 4, caractérisé par le fait que le processeur de synchronisation et de déviation (17) présente, outre le décodeur de bus (12), la mémoire de données (13), un circuit de préparation de signal synchrone (24) commuté efficacement par les ordres de réglage et servant à engendrer les signaux synchrones horizontal et vertical ainsi que des signaux synchrones de couleur et des signaux auxiliaires (sand castle-impulse).